# EUROPEAN PATENT SPECIFICATION

(11) **EP 3 761 355 B1**
(45) Date of publication and mention of the grant of the patent: **27.04.2022**
(21) Application number: 19757161.5
(22) Date of filing: 25.02.2019
(51) Int. Cl.: H01L 23/373, H01L 23/42, H05K 7/20, C08L 83/04, C08K 3/40, C08K 3/38, C08G 77/04, C09D 183/04

(54) **INSULATING HEAT DISSIPATION SHEET**
ISOLIERENDE WÄRMEABLEITUNGSFOLIE
FEUILLE DE DISSIPATION DE CHALEUR ISOLANTE

(30) Priority: 26.02.2018 JP 2018031855
(43) Date of publication of application: 06.01.2021
(73) Proprietor: Denka Company Limited, Tokyo 103-8338 (JP)
(72) Inventor: WADA,Kosuke, Omuta-city, Fukuoka 836-8510 (JP); YAMAGATA,Toshitaka, Omuta-city, Fukuoka 836-8510 (JP); KANEKO,Masahide, Omuta-city, Fukuoka 836-8510 (JP)
(74) Representative: Gulde & Partner
(86) International application number: PCT/JP2019/007140
(87) International publication number: WO 2019/164002

(56) References cited:
- EP-A1- 2 610 277
- WO-A1-2016/092734
- JP-A- 2003 060 134
- JP-A- 2008 189 818
- JP-A- 2011 006 586
- JP-A- 2013 053 180
- JP-A- 2017 222 522

## Description

### Technical Field

The present invention relates to an insulating heat dissipation sheet excellent in thermal conductive property and insulation and use thereof, and relates to the insulating heat dissipation sheet capable of being incorporated into an electronic device without damaging heat generating electronic components such as a power device, a transistor, a thyristor, and a CPU (central processing unit) particularly when used as a heat dissipation member for an electronic component.

### Background Art

In heat generating electronic components such as power devices, transistors, thyristors, and CPUs, it is important to remove heat generated during use thereof. Conventionally, as such a method of removing heat, heat generating electronic components are commonly provided to heat dissipation fins or metal plates through an insulating heat dissipation sheet having electrical insulation to release heat, and as the insulating heat dissipation sheet, those obtained by dispersing a thermal conductive filler in silicone rubber are used.

In recent years, higher integration of circuits in electronic components has induced higher amount of generated heat, and materials having more improved thermal conductive property than ever before have been demanded. In addition, with the performance improvement of the above electronic members, the insulating layer used also tends to be thinner than the conventional several hundred µm and the thickness thereof may be several tens µm or more and 100 µm or less, and the corresponding filler has also been required to be reduced in particle size from the conventional several hundred µm to 100 µm or less.

However, for hexagonal boron nitride particles used as fillers, the thermal conductivity in the in-plane direction (a-axis direction) is 400 W/(m·K), while the thermal conductivity in the thickness direction (c-axis direction) is 2 W/(m·K), which indicates that thermal conductivity anisotropy derived from the crystal structure and scaly shape is large. Furthermore, when the hexagonal boron nitride powder is filled in a resin, the particles are oriented in the same direction. Therefore, for example, when thermal interface materials are manufactured, the in-plane direction (a-axis direction) of the hexagonal boron nitride particles is perpendicular to the thickness direction of the thermal interface material, and therefore the high thermal conductivity in the in-plane direction (a-axis direction) of the hexagonal boron nitride particles has been insufficiently utilized.

Patent Literature 1 has proposed those having the in-plane direction (***a***-axis direction) of the scaly boron nitride particles oriented in the thickness direction of the high thermal conductive sheet, and may utilize the high thermal conductivity in the in-plane direction (***a-***axis direction) of the hexagonal boron nitride particles. However, the prior art described in Patent Literature 1 has had problems: (1) the oriented sheet needs to be laminated in the next step, and the manufacturing step tends to be complicated, and (2) it is necessary to cut into a thin sheet after lamination and curing, making it difficult to ensure dimensional accuracy in sheet thickness. In addition, the influence of the shape of the scaly boron nitride particles increases the viscosity in filling in a resin, easily forms voids, and decreases the insulation. In addition, the formed voids are coarse or continuous in the thickness direction of the sheet, leading to a problem that securing insulation is difficult.

In order to improve these, various shapes of the boron nitride powder suppressing the anisotropy of the thermal conductivity of the scaly boron nitride particles have been proposed.

Patent Literature 2 has proposed the use of a boron nitride powder in which scaly boron nitride particles as primary particles are aggregated without being oriented in the same direction and may suppress the thermal conductivity anisotropy, and the aggregate particles of boron nitride used for this are spherical and therefore have good fluidity and the average particle size is 20 to 180 µm. However, when the average particle size is 100 µm or more, the thickness of the thermal interface material may not be reduced, and therefore the thermal resistance was high, the heat dissipation was low, and the thermal conductivity only achieved about 6 W/(m·K). In addition, the average particle size is in a single mode and therefore many voids and/or a large resin layer is formed between the particles, resulting in poor insulation and formability.

In Patent Literature 3, aggregate particles obtained by aggregating scaly boron nitride having a plurality of average particle sizes are mixed and aggregated boron nitride particles having a particle size of more than 60 µm and 300 µm or less are included in a ratio of 10 to 40% by volume, and the thickness of the thermal interface material may not be reduced. As a result, the thermal resistance increases, the heat dissipation is low, and the inclusion of aggregated boron nitride particles having a particle size of 100 µm or more tends to form voids in the aggregate particles, leading to low insulation. In addition, the matrix resin is an acrylic polymer component and therefore the heat resistance temperature is as low as about 100°C, and in using as a thermal interface material, the use is limited.

In Patent Literature 4, aggregated boron nitride particles having a plurality of the average particle sizes are mixed, but the particle size frequency distribution has a maximal value in the region of 100 to 300 µm, and therefore the thickness of the thermal interface material may not become thin, resulting in high thermal resistance and low heat dissipation. In addition, the inclusion of aggregated boron nitride having a particle size of 100 µm or more tends to form voids in the aggregate particles, leading to low insulation.

Patent Literatures 5, 6 and 7 describe further dissipation sheets and/or resin compositions.

### Citation List

### Patent Literature

Patent Literature 1: Japanese Patent Laid-Open No. 2000-154265
Patent Literature 2: Japanese Patent Laid-Open No. 2010-157563
Patent Literature 3: Japanese Patent Laid-Open No. 2008-189818
Patent Literature 4: Japanese Patent Laid-Open No. 2005-343728
Patent Literature 5: WO 2016/092734 A1
Patent Literature 6: JP 2017 222522 A
Patent Literature 7: JP 2013 053180 A

### Summary of Invention

### Technical Problem

An object of the present invention is to provide an insulating heat dissipation sheet excellent in both thermal conductive property and insulation, particularly, is to provide an insulating heat dissipation sheet suitable as a heat dissipation member for electronic components.

### Solution to Problem

Specifically, the present invention may provide the following in order to solve the above problems.

Provided is an insulating heat dissipation sheet containing hexagonal boron nitride and a silicone resin, wherein the particle size frequency distribution of the hexagonal boron nitride has maximal peaks in a range of 35 to 100 µm, and in a range of 10 to 25 µm and/or in a range of 0.4 to 5 µm; the average particle size of the hexagonal boron nitride is in a range of 30 to 80 µm; and the insulating heat dissipation sheet comprises a silicone composition containing the hexagonal boron nitride in a content of 40 to 70% by volume and the silicone resin in a content of 30 to 60% by volume. Preferably, the insulating heat dissipation sheet further containing a glass cloth having a thickness of 10 to 150 µm may also be provided. Preferably, a heat dissipation member obtained using the above insulating heat dissipation sheet may also be provided.

### Advantageous Effects of Invention

The present invention may provide an insulating heat dissipation sheet having both high thermal conductivity and high insulation, and particularly, may provide an insulating heat dissipation sheet suitable as a heat dissipation member for electronic components.

### Description of Embodiments

Hereinafter, the present invention will be described in detail. Unless otherwise specified, a numerical range described in the present description means a numerical range including both a lower limit and an upper limit of a certain range.

The average particle size of the hexagonal boron nitride used in the embodiment of the present invention needs to be 30 to 80 µm, and more preferably the average particle size is in the range of 45 to 70 µm. When the average particle size is more than 80 µm, the gap when the particles come into contact with each other increases, and the thermal conductive property tends to be deteriorated. Conversely, when the average particle size is less than 30 µm, the filling property of the particles into the thermosetting resin tends to be deteriorated, and the thermal conductive property tends to be deteriorated. In the form of hexagonal boron nitride, primary particles are scaly particles due to its crystal structure. The boron nitride in a form in which a plurality of the scaly particles is aggregated is an aggregate particle, and the shape is spherical or angular.

The average particle size of the hexagonal boron nitride is in the range of 30 to 80 µm, and in the particle size frequency distribution of the hexagonal boron nitride, there is at least one maximal peak (i.e., local maximum peak) in a region of 35 to 100 µm (hereinafter, referred to as "maximal peak 1"), and there is at least one maximal peak each in a region of 10 to 25 µm (hereinafter, referred to as "maximal peak 2") and/or in a region of 0.4 to 5 µm (hereinafter, referred to as "maximal peak 3"). This allows the hexagonal boron nitride to be more highly filled, and the thermal conductive property may be further enhanced by increasing the contact points of the particles. In addition, when the filling amount is the same in the high filling, the particles are densely packed with each other, and therefore slippage is improved and the fluidity may maintain being high. Furthermore, in the case of a silicone composition having such a particle size distribution, the impregnation rate of a glass cloth with respect to a glass fiber bundle is improved, and therefore the thermal conductivity and the insulation may be significantly improved.

For the particle shape of the hexagonal boron nitride in the silicone composition, boron nitrides having the maximal peak 1 and the maximal peak 2 are often composed of aggregate particles obtained by aggregating scaly particles of the hexagonal boron nitride, and boron nitride having the maximal peak 3 is mainly composed of scaly particles. The boron nitride having the maximal peak 1 and the boron nitride having the maximal peak 2 are aggregate particles and thus have low orientation, and their thermal conductivity in the thickness direction of the sheets is each high. The thermal conductivity may be significantly increased by filling the space between the particles of the maximal peak 1 with the particles of the maximal peak 2 and the maximal peak 3. The particles of the maximal peak 3 shows a scaly shape with a very small particle size, and has the effect of filling the space formed between the particles having the maximal peak 1 and bringing those particles into surface contact, thus being able to contribute to an improvement in thermal conductivity and formability.

The content of the hexagonal boron nitride in the silicone composition is preferably 40 to 70% by volume, particularly preferably 53 to 63% by volume, and the content of the silicone resin is preferably 30 to 60% by volume, particularly preferably 37 to 47% by volume. When the content of the hexagonal boron nitride is more than 70% by volume or the blend ratio of the silicone resin is less than 30% by volume, the viscosity of the composition rises and the formability is impaired, and voids are formed in the heat dissipation sheet, which may cause the insulation to be reduced. When the content of the boron nitride is less than 40% by volume or the blend ratio of the silicone resin is more than 60% by volume, the thermal conductive property of the composition is difficult to be sufficiently enhanced.

The thickness of the insulating heat dissipation sheet according to the embodiment of the present invention is preferably 100 to 1000 µm, and more preferably 150 to 650 µm. Here, setting the position of the "maximal peak 1" at 100 µm or less may reduce the sheet thickness to 100 µm, and thus obtain an insulating heat dissipation sheet having both high heat dissipation and high insulation.

The dielectric breakdown strength of the present insulating heat dissipation sheet is preferably 25 kV/mm or more. Here, setting the position of the "maximal peak 1" to 100 µm or less may suppress the formation of voids due to the aggregate particles of the hexagonal boron nitride, and a dielectric breakdown strength of 25 kV/mm or more may be obtained.

Furthermore, in some embodiments, a thermal conductive powder such as aluminum oxide, magnesium oxide, silicon oxide, silicon nitride, carbon nanotube, and carbon powder may be used in combination as long as heat dissipation is not impaired.

In the present description, the average particle size of the hexagonal boron nitride may be measured, for example, by using a "laser diffraction type particle size distribution measuring apparatus SALD-200" manufactured by Shimadzu Corporation as follows. A solution obtained by dispersing 5 g of a hexagonal boron nitride powder in 50 CC of pure water is added drop by drop to the sampler section of the apparatus by using a dropper, and is left for stabilization until the absorbance may be measured. In this way, the measurement is performed when the absorbance becomes stable. In the laser diffraction type particle size distribution measuring apparatus, the particle size distribution is calculated from the data of the light intensity distribution of the diffraction or scattered light from the particles detected by the sensor. The average particle size is determined by multiplying the measured value of the particle size by the relative particle amount (% difference) and dividing by the total relative particle amount (100%). The average particle size is the average diameter of the particles.

The thermosetting resin usable in the embodiment of the present invention is typically a millable silicone, but it is often difficult to develop the required flexibility as a whole and therefore an addition-reaction-type silicone is suitable for developing high flexibility.

According to a preferred embodiment, the silicone composition comprises an addition-reaction-type silicone. Specific examples of the addition-reaction-type liquid silicone include: a one-component-reaction type organopolysiloxane having both a vinyl group and an H-Si group in one molecule; or a two-part silicone composed of an organopolysiloxane having a vinyl group at the terminal or side chain and an organopolysiloxane having two or more H-Si groups at the terminal or side chain. For example, there is a trade name "LR3303A/B" manufactured by Asahi Kasei Wacker Silicone Co., Ltd.

The addition-reaction-type liquid silicone may be used in combination of a reaction retarder such as acetyl alcohols and maleic acid esters, and a thickener, a flame retardant, a pigment, and a softener such as aerosil having a size of ten to several hundred µm, silicone powder, and silicone oil.

The insulating heat dissipation sheet having a ceramic powder dispersed and filled in an organic resin may be reduced in thickness to 100 µm and may have flexibility, so that the degree of freedom in the mounting method may be enhanced. Furthermore, an insulating heat dissipation sheet capable of being used up to a heat resistance temperature of about 200°C, having excellent environmental resistance, and capable of being used in various environments may be obtained.

### [Reinforcing layer]

The reinforcing layer capable of being used in the insulating heat dissipation sheet according to the embodiment of the present invention plays a role of providing mechanical strength to the insulating heat dissipation sheet, and further has an effect of suppressing the stretching of the insulating heat dissipation sheet in the planar direction and securing the insulation. The material for the reinforcing layer may be arbitrarily selected according to the use of the insulating heat dissipation sheet. For example, a heat dissipation sheet in the field of electronic materials preferably includes a glass cloth, a resin film (such as polyester, polyamide, polyimide, polycarbonate, and acrylic resin), a cloth fiber mesh cloth (such as cotton, hemp, aramid fiber, cellulose fiber, nylon fiber, and polyolefin fiber), a non-woven fabric (such as aramid fiber, cellulose fiber, nylon fiber, and polyolefin fiber), a metal fiber mesh cloth (such as stainless steel, copper, and aluminum), or a metal foil (such as copper foil, nickel foil, and aluminum foil). Particularly, it is preferable to include a glass cloth from the viewpoint of the thermal conductive property and insulation.

When a glass cloth is included in the reinforcing layer, a glass cloth having an opening as commercially available in general may be used. From the viewpoint of the thermal conductive property, for example, the thickness of the glass cloth may be in the range of 10 µm to 150 µm, more preferably in the range of 20 to 90 µm, and still more preferably in the range of 30 to 60 µm. When the thickness of the glass cloth is less than 10 µm, reduction of the strength of the insulating heat dissipation sheet causes the equipment to be destroyed during handling, making it impossible to form a sheet, and when is more than 150 µm, the thermal conductivity may be reduced. Furthermore, some commercially available glass cloths have a fiber size of 4 to 9 µm, and these may be used. Moreover, the tensile strength of the glass cloth may be, for example, in the range of 100 to 1000 N/25 mm. In addition, the length of one side of the opening of the glass cloth may be, for example, in the range of 0.1 mm or more and 1.0 mm or less, from the viewpoint of balancing the thermal conductive property and strength. For example, there is a trade name "H25 F104" manufactured by Unitika Co., Ltd.

The method of applying the insulating heat dissipation sheet is not particularly limited, and known applying methods such as a doctor blade method, a comma coater method, a screen printing method, and a roll coater method, allowing for uniform application, may be adopted, but considering the thickness accuracy of the silicone composition, the doctor blade method and the comma coater method are preferable.

For the joining between the silicone composition and the glass cloth in the insulating heat dissipation sheet, the silicone resin composition is applied on a PET film, and then it is preferable to use a heating press machine and perform joining at a temperature of 80°C to 170°C for 10 to 60 minutes under the conditions of a pressure of 100 to 200 kg/cm² in an air atmosphere. When the pressure is less than 100 kg/cm² and when the joining temperature is less than 80°C, or when the joining time is less than 10 minutes, the joining property between the silicone composition and the glass cloth is reduced. On the other hand, the case where the pressure is more than 200 kg/cm², the case where the joining temperature is more than 170°C, or the case where the joining time is more than 60 minutes is unpreferable from the viewpoint of lowering productivity and increasing costs. However, this is not the case when the atmosphere in joining is nitrogen, argon, hydrogen, or vacuum. Thereafter, it is preferable to perform secondary heating under the conditions of 130 to 250°C for 5 to 30 hours to remove the low-molecular siloxane from the silicone resin, and to cure the silicone resin.

The thermal conductivity in the present description may be calculated by, for example, multiplying all of the thermal diffusivity, density, and specific heat of a resin composition based on ASTM E-1461 (thermal conductivity = thermal diffusivity × density × specific heat). The thermal diffusivity may be determined, for example, by processing a sample to a width of 10 mm × 10 mm × a thickness of 0.5 mm and by using a laser flash method. The measurement may be performed at 25°C by using a xenon flash analyzer ("LFA447 NanoFlash", manufactured by NETSCH Co., Ltd.) for a measuring apparatus. The density is determined by using the Archimedes method. The specific heat may be determined by using, for example, DSC ("ThermoPlus Evo DSC8230", manufactured by Rigaku Corporation).

### Examples

The measurement of the dielectric breakdown strength of the sheet was based on JISC2110. The insulating heat dissipation sheet to be measured was processed into a size of 10 cm × 10 cm, and a test sample was produced so as to have a circular copper layer of φ25 mm on one surface and a copper layer on the other entire surface. Electrodes were arranged so as to sandwich the test sample, and in an electric insulating oil (product name FC-3283, manufactured by 3M Co., Ltd.), the AC voltage was raised to the test sample at a constant rate (500 V/s) at which a dielectric breakdown occurred in 0 to 10 to 20 seconds on average. The dielectric breakdown strength (unit: kV/mm) was determined by dividing the voltage (unit: kV) at which the dielectric breakdown occurred by the thickness (unit: mm) of the insulating heat dissipation sheet.

### (Example 1)

Hexagonal boron nitride was prepared by the following procedure.

Boric acid, melamine, and calcium carbonate (all of which are guaranteed reagents) were mixed at a mass ratio of 70:50:5, and in a nitrogen gas atmosphere, the temperature thereof was raised from room temperature to 1400°C in 1 hour, held at 1400°C for 3 hours, raised to 1900°C in 4 hours, held at 1900°C for 2 hours, and cooled to room temperature to manufacture hexagonal boron nitride. This was disintegrated, pulverized, and sieved to prepare aggregate powder A, aggregate powder B and aggregate powder C. On the other hand, a commercially available boron nitride sintered body (trade name "DENCABORON NITRIDE MOLDED NB-1000" manufactured by Denka Co., Ltd.) was disintegrated, pulverized, and sieved to prepare aggregate powder D, aggregate powder E, and aggregate powder F. In addition, a commercially available boron nitride powder (trade name "DENCABORON NITRIDE POWDER SGPS" manufactured by Denka Co., Ltd.) was sieved to prepare aggregate powder G and aggregate powder H. Furthermore, a commercially available trade name "DENKA BORON NITRIDE SP-3" manufactured by Denka Co., Ltd. was disintegrated and sieved to prepare scaly powder I, scaly powder J, scaly powder K, and scaly powder L. In addition, scaly powder M (trade name "DENCABORON NITRIDE XGP" manufactured by Denka Co., Ltd.) was prepared. Table 1 shows the properties of these powders. Even after mixing arbitrary powders of the maximum peaks 1 to 3, it was possible to confirm each peak as before mixing.

"LR3303A/B" manufactured by Asahi Kasei Wacker Silicone Co., Ltd. was used for a silicone resin component, a boron nitride powder was filled at a filling percentage (% by volume) shown in Table 2, toluene was weighed as a viscosity modifier so that the solid content was 60 wt%, and mixing was performed for 15 hours by using a turbine type stirring blade with a stirrer "Three One Motor" manufactured by HEIDON Co., Ltd. to prepare a boron nitride-containing silicone composition.

The above silicone composition was applied on a PET film to a thickness of 0.5 mm per side with a comma coater, and dried at 75°C for 5 minutes. Thereafter, pressing was performed at a temperature of 150°C and a pressure of 150 kgf/cm² for 45 minutes by using a flat press machine manufactured by Yanase Seisakusho Co., Ltd. to produce a sheet having a thickness of 0.3 mm. Then, this sheet was subjected to secondary heating at 150°C for 4 hours under normal pressure to obtain an insulating heat dissipation sheet.

### (Example 2)

An insulating heat dissipation sheet was produced in the same manner as in Example 1 except that the conditions shown in Table 2 were used.

### (Example 3)

Using the conditions shown in Table 2, the application was performed on a glass cloth (trade name "H25" manufactured by Unitika Co., Ltd.) as a reinforcing layer with a comma coater to 0.2 mm per side, drying was performed at 75°C for 5 minutes, and the application was performed again on the other side of the glass cloth with the comma coater to a thickness of 0.2 mm to produce a multilayer product. Thereafter, pressing was performed at a temperature of 150°C and a pressure of 150 kgf/cm² for 45 minutes by using a flat press machine manufactured by Yanase Seisakusho Co., Ltd. to produce a sheet having a thickness of 0.3 mm. Then, this sheet was subjected to secondary heating at 150°C for 4 hours under normal pressure to obtain an insulating heat dissipation sheet.

### (Examples 4 to 22 and Comparative Examples 1 to 10)

Insulating heat dissipation sheets were produced in the same manner as in Example 3 except that the conditions shown in Tables 2 and 3 were used.

### (Evaluation)

The thermal conductivities of the heat dissipation sheets in Examples 1 to 22 and Comparative Examples 1 to 10 were evaluated. The results are shown in Tables 2 and 3. In the case where the insulating heat dissipation sheet was not able to be normally manufactured in the form of a sheet (due to looseness or cracks on the surface), "Sheet producibility" is described as "Impossible".

From Examples in Table 2 and Comparative Examples in Table 3, it may be seen that the insulating heat dissipation sheet of the present invention has excellent thermal conductive property and dielectric breakdown strength.

**[Table 1]**

| Powder name | Peak (µm) | Particle size distribution | | | |
|---|---|---|---|---|---|
| | | Maximal peak 1 | Maximal peak 2 | Maximal peak 3 | Other |
| Aggregate powder A | 150 | | | | 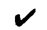 |
| Aggregate powder B | 75 | 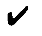 | | | |
| Aggregate powder C | 13 | | 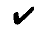 | | |
| Aggregate powder D | 85 | 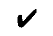 | | | |
| Aggregate powder E | 29 | | | | 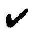 |
| Aggregate powder F | 6 | | | | 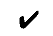 |
| Aggregate powder G | 42 | 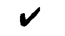 | | | |
| Aggregate powder H | 21 | | 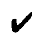 | | |
| Scaly powder I | 3 | | | 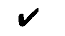 | |
| Scaly powder J | 1 | | | 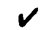 | |
| Scaly powder K | 0.5 | | | 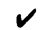 | |
| Scaly powder L | 0.1 | | | | 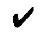 |
| Scaly powder M | 29 | | | | 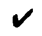 |

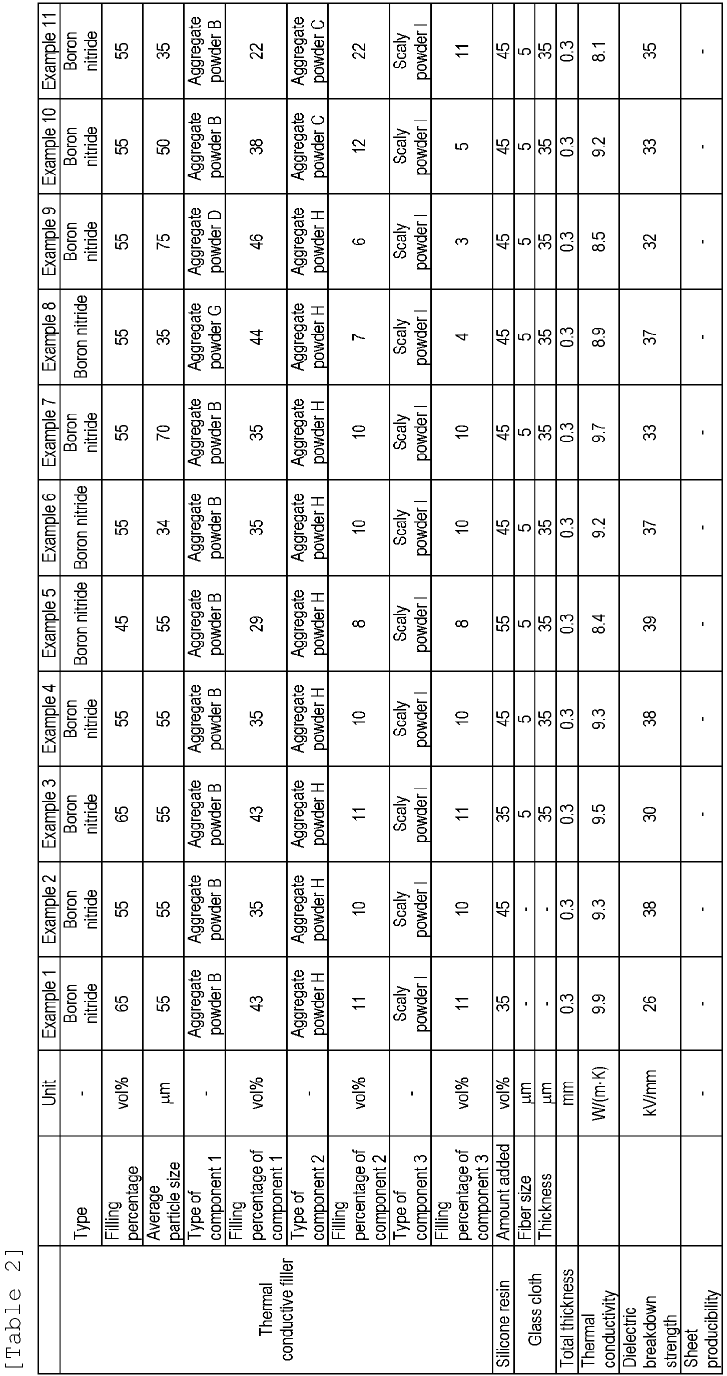

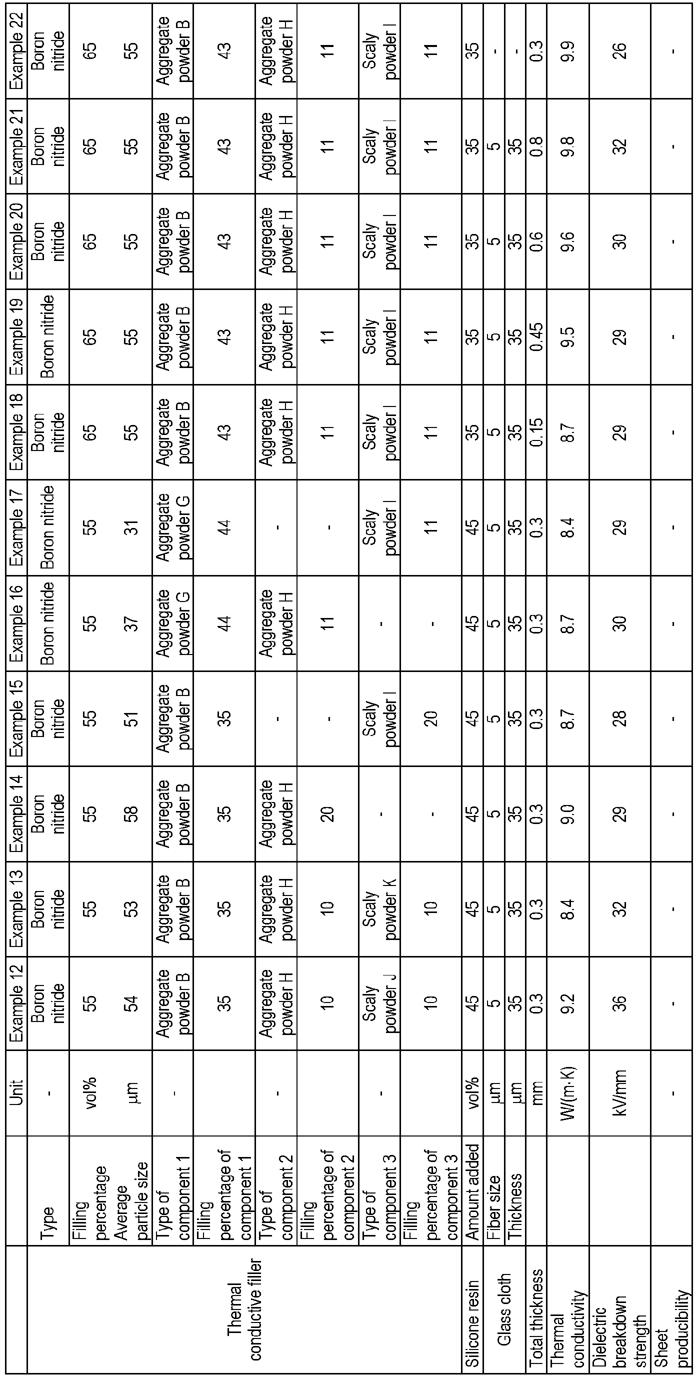

**[Table 3]**

| | | Unit | Comparative Example 1 | Comparative Example 2 | Comparative Example 3 | Comparative Example 4 | Comparative Example 5 |
|---|---|---|---|---|---|---|---|
| Thermal conductive filler | Type | - | Boron nitride | Boron nitride | Boron nitride | Boron nitride | Boron nitride |
| | Filling percentage | vol% | 30 | 80 | 55 | 55 | 55 |
| | Average particle size | µm | 55 | 55 | 105 | 22 | 29 |
| | Type of component 1 | - | Aggregate powder B | Aggregate powder B | Aggregate powder A | Aggregate powder E | Aggregate powder G |
| | Filling percentage of component 1 | | 20 | 52 | 35 | 35 | 38 |
| | Type of component 2 | - | Aggregate powder H | Aggregate powder H | Aggregate powder H | Aggregate powder H | - |
| | Filling percentage of component 2 | | 5 | 14 | 10 | 10 | - |
| | Type of component 3 | - | Scaly powder I | Scaly powder I | Scaly powder I | Scaly powder I | Scaly powder L |
| | Filling percentage of component 3 | | 5 | 14 | 10 | 10 | 17 |
| Silicone resin | Amount added | vol% | 70 | 20 | 30 | 30 | 45 |
| Glass cloth | Fiber size | µm | 5 | 5 | 5 | 5 | 5 |
| | Thickness | µm | 35 | 35 | 35 | 35 | 35 |
| Total thickness | | mm | 0.3 | - | - | 0.3 | 0.3 |
| Thermal conductivity | | W/(m·K) | 5.5 | - | - | 4.2 | 6.0 |
| Dielectric breakdown strength | | kV/mm | 38 | - | - | 30 | 21 |
| Sheet producibility | | - | - | Impossible | Impossible | - | - |
| | | Unit | Comparative Example 6 | Comparative Example 7 | Comparative Example 8 | Comparative Example 9 | Comparative Example 10 |
| Thermal conductive filler | Type | - | Boron nitride | Boron nitride | Boron nitride | Boron nitride | Boron nitride |
| | Filling percentage | vol% | 65 | 55 | 45 | 65 | 55 |
| | Average particle size | µm | 75 | 75 | 75 | 21 | 21 |
| | Type of component 1 | - | Aggregate powder B | Aggregate powder B | Aggregate powder B | - | - |
| | Filling percentage of component 1 | | 65 | 55 | 45 | - | - |
| | Type of component 2 | | - | - | - | Aggregate powder H | Aggregate powder H |
| | Filling percentage of component 2 | | - | - | - | 65 | 55 |
| | Type of component 3 | - | - | - | - | - | - |
| | Filling percentage of component 3 | | - | - | - | - | |
| Silicone resin | Amount added | vol% | 35 | 45 | 55 | 35 | 45 |
| Glass cloth | Fiber size | µm | 5 | 5 | 5 | 5 | 5 |
| | Thickness | µm | 35 | 35 | 35 | 35 | 35 |
| Total thickness | | mm | 0.3 | 0.3 | 0.3 | 0.3 | 0.3 |
| Thermal conductivity | | W/(m·K) | 6.0 | 5.8 | 4.2 | 4.3 | 3.6 |
| Dielectric breakdown strength | | kV/mm | 17 | 19 | 20 | 12 | 14 |
| Sheet producibility | | - | - | - | - | - | - |

### Industrial Applicability

Use of the insulating heat dissipation sheet of the present invention as a heat dissipation member for electronic components, for example, use as a heat dissipation member of a semiconductor element such as a power device, allows for long-term use.

## Claims

1. An insulating heat dissipation sheet, comprising a silicone composition containing:
a silicone resin in a content of 30 to 60% by volume;
hexagonal boron nitride in a content of 40 to 70% by volume, wherein
a particle size frequency distribution of the hexagonal boron nitride has maximal peaks in a range of 35 to 100 µm, and in a range of 10 to 25 µm and/or in a range of 0.4 to 5 µm, and
an average particle size of the hexagonal boron nitride is in a range of 30 to 80 µm.

2. The insulating heat dissipation sheet according to claim 1, further comprising
a glass cloth having a thickness of 10 µm to 150 µm.

3. The insulating heat dissipation sheet according to any of claims 1 or 2, wherein
the silicone composition comprises an addition-reaction-type silicone.

4. A heat dissipation member obtained by using the insulating heat dissipation sheet according any of claims 1 to 3.

## Patentansprüche

1. Isolierende Wärmeableitungsfolie, umfassend eine Silikonzusammensetzung, enthaltend:
ein Silikonharz mit einem Anteil von 30 bis 60 Volumen%;
hexagonales Bornitrid mit einem Anteil von 40 bis 70 Volumen%, wobei
die Partikelgrößenhäufigkeitsverteilung des hexagonalen Bornitrids Spitzenwerte in einem Bereich von 35 bis 100 µm und in einem Bereich von 10 bis 25 µm und/oder in einem Bereich von 0,4 bis 5 µm aufweist und
eine durchschnittliche Partikelgröße des hexagonalen Bornitrids in einem Bereich von 30 bis 80 µm liegt.

2. Isolierende Wärmeableitungsfolie nach Anspruch 1, ferner umfassend ein Glasgewebe mit einer Dicke von 10 µm bis 150 µm.

3. Isolierende Wärmeableitungsfolie nach einem der Ansprüche 1 oder 2, wobei die Silikonzusammensetzung ein Silikon vom Additionsreaktionstyp ist.

4. Wärmeableitungselement, erhalten unter Verwendung der isolierenden Wärmeableitungsfolie nach einem der Ansprüche 1 bis 3.

## Revendications

1. Feuille isolante de dissipation de chaleur, comprenant une composition de silicone contenant :
une résine de silicone en une teneur de 30 à 60 % en volume ;
du nitrure de bore hexagonal en une teneur de 40 à 70 % en volume, dans laquelle
une distribution de fréquence de taille de particule du nitrure de bore hexagonal a des pics maximaux dans une plage allant de 35 à 100 µm, et dans une plage allant de 10 à 25 µm et/ou dans une plage allant de 0,4 à 5 µm, et
une taille de particule moyenne du nitrure de bore hexagonal est dans une plage allant de 30 à 80 µm.

2. Feuille isolante de dissipation de chaleur selon la revendication 1, comprenant en outre
un tissu de verre ayant une épaisseur de 10 µm à 150 µm.

3. Feuille isolante de dissipation de chaleur selon l'une quelconque des revendications 1 ou 2, dans laquelle
la composition de silicone comprend une silicone de type réactionnel par addition.

4. Élément de dissipation de chaleur obtenu en utilisant la feuille isolante de dissipation de chaleur selon l'une quelconque des revendications 1 à 3.
